# DEMANDE DE BREVET EUROPEEN

(11) **EP 2 830 086 A1**
(43) Date de publication de la demande: **28.01.2015**
(21) Numéro de dépôt: 14178363.9
(22) Date de dépôt: 24.07.2014
(51) Int. Cl.: H01L 21/28, H01L 29/423, H01L 21/3213

(54) **Procédé de fabrication d'un espaceur pour cellule mémoire électronique a double grille et cellule mémoire électronique associée**

(30) Priorité: 26.07.2013 FR 1357379
(71) Demandeur: COMMISSARIAT A L'ENERGIE ATOMIQUE ET AUX ENERGIES ALTERNATIVES, 75015 Paris (FR)
(72) Inventeur: De Luca, Anthony, 38640 CLAIX (FR); Charpin-Nicolle, Christelle, 38120 FONTANIL-CORNILLON (FR)
(74) Mandataire: Lebkiri, Alexandre

(57) **Abrégé**

L'invention concerne un procédé de fabrication d'un espaceur (311, 312) pour mémoire électronique comportant :
- un substrat (300) ;
- une première structure de grille (301) ;
- un empilement (304) comprenant plusieurs couches et dont au moins une desdites couches est apte à stocker des charges électriques.

Ce procédé comporte les étapes suivantes :
- dépôt d'une couche d'un matériau de l'espaceur au moins sur la zone recouverte par l'empilement (304) ;
- usinage ionique de la couche du matériau de l'espaceur, ledit usinage ionique s'effectuant avec arrêt contrôlé de manière à conserver un reliquat de l'épaisseur de la couche du matériau de l'espaceur recouvrant l'empilement (304) ;
- gravure plasma du reliquat de l'épaisseur de la couche du matériau de l'espaceur.

## Description

### DOMAINE TECHNIQUE DE L'INVENTION

Le domaine technique de l'invention est celui des procédés de fabrication des cellules mémoires double grille (grille du transistor de mémorisation et grille du transistor de commande) possédant une architecture « split-gate ». Dans une cellule mémoire électronique à double grille split-gate, la grille du transistor de mémorisation peut être réalisée sous la forme d'un espaceur de la grille du transistor de commande, disposé contre un des deux flancs latéraux de la grille du transistor de commande. De telles cellules mémoires électroniques trouvent une application particulièrement intéressante dans le domaine de l'électronique embarquée.

Le domaine de l'invention concerne plus particulièrement les procédés de fabrication d'espaceurs pour cellule mémoire électronique à double grille.

### ARRIERE-PLAN TECHNOLOGIQUE DE L'INVENTION

La fabrication standard d'espaceurs par gravure sèche est une technique couramment utilisée en microélectronique. Cette technique permet d'obtenir des résultats reproductibles, de combiner la possibilité d'avoir des profils de gravure relativement droits et d'obtenir généralement de bonnes « sélectivités » de gravure, c'est-à-dire de pouvoir s'arrêter sur un autre matériau sans trop consommer ce dernier. En revanche, elle ne permet pas d'obtenir des espaceurs volumineux ni de contrôler la largeur desdits espaceurs. Le document « Highly Reliable Flash Memory with Self-aligned Split-gate Cells Embedded into High Performance 65 nm CMOS for Automotive ans Smartcard Applications » ((IMW2012) de D. Shum et al.) mentionne que le profil d'espaceur obtenu en utilisant des procédés conventionnels de microélectronique est sensiblement triangulaire. Un espaceur avec un tel profil triangulaire possède deux principaux inconvénients :
- L'épaisseur de l'espaceur n'est pas suffisante en bord des motifs triangulaires, le dopage du drain n'est donc pas très bien contrôlé. Idéalement, il faudrait un espaceur carré avec une épaisseur suffisamment importante pour ne pas avoir de contre-dopage potentiel.
- La largeur et le volume de siliciuration en haut de l'espaceur sont peu importants et la reprise des contacts est difficile à effectuer.

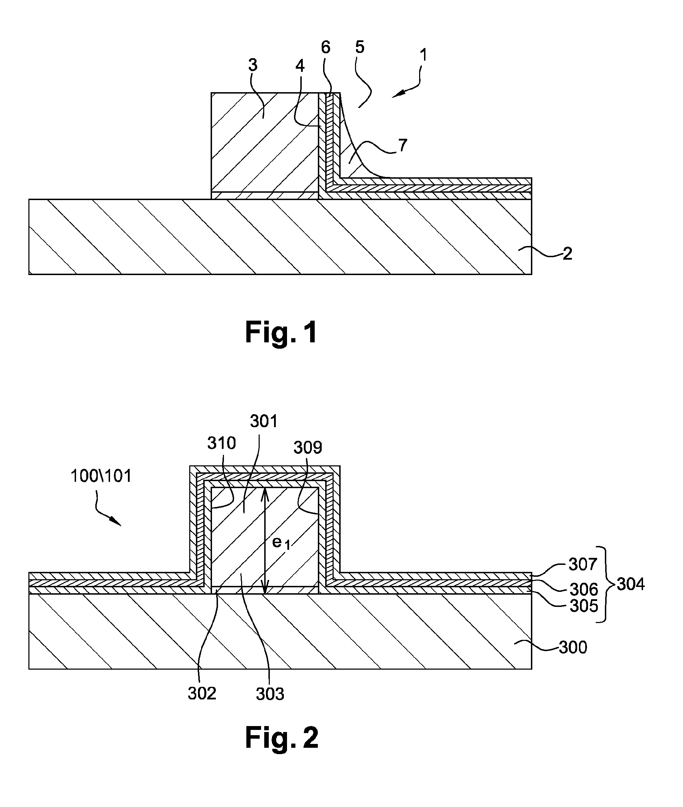

Une telle structure est illustrée par la figure 1 qui représente schématiquement une cellule mémoire 1 à double grille avec une architecture split-gate dans laquelle la grille du transistor de mémorisation est réalisée sous la forme d'un espaceur de la grille du transistor de commande.

La mémoire 1 comporte un substrat 2 réalisé dans un matériau semi-conducteur, une zone conductrice de grille du transistor de commande 3 présentant un flanc latéral 4 et un espaceur latéral 5 disposé contre le flanc latéral 4 de la grille du transistor de commande 3. Cet espaceur latéral 5 comprend notamment :
- un empilement 6 tri-couches diélectrique, par exemple d'oxyde-nitrure-oxyde (dit empilement ONO), la couche de nitrure servant à stocker des charges électriques ;
- une zone conductrice de grille 7 du transistor de mémorisation de forme sensiblement triangulaire.

Toutefois, avec une telle structure, il est très difficile de réaliser ensuite une reprise de contact électrique sur la zone conductrice du transistor de mémorisation 7 : la surface accessible pour une reprise de contact est très réduite. De plus, en bord d'espaceur, l'épaisseur de la zone conductrice de grille 7 du transistor de mémorisation est très fine et mal contrôlée ; la zone de dopage du drain sera donc elle-même mal contrôlée.

Le document US20110070726A1 propose un procédé de fabrication d'un espaceur dont la forme n'est pas triangulaire. Selon ce procédé de fabrication, un matériau protecteur est déposé sur le matériau de l'espaceur préalablement à la gravure de l'espaceur. Le matériau protecteur peut contenir du carbone, il peut également être un diélectrique, par exemple à base d'oxyde ou de nitrure, comme du nitrure de silicium. Le matériau protecteur peut être hautement sélectif par rapport au matériau de l'espaceur. Ce matériau protecteur contribue à l'obtention d'un espaceur ayant une forme non triangulaire et dont les flancs latéraux sont sensiblement verticaux. Le procédé de fabrication proposé par le document US20110070726A1 nécessite cependant un enchaînement d'étapes technologiques supplémentaires, ce qui le rend plus complexe et onéreux.

### DESCRIPTION GENERALE DE L'INVENTION

Le procédé selon l'invention offre une solution aux problèmes évoqués précédemment, en permettant l'obtention d'une cellule mémoire électronique à double grille (grille du transistor de commande et grille du transistor de mémorisation), dans laquelle la grille du transistor de mémorisation est réalisée sous la forme d'un espaceur de la grille du transistor de commande, ledit espaceur possédant un volume de matériau important, par un procédé plus simple (ne nécessitant pas d'avoir recours à des dépôts d'autres matériaux) et donc moins onéreux que celui proposé dans l'état de la technique.

Un premier objet de l'invention concerne un procédé de fabrication d'un espaceur pour mémoire électronique, la mémoire électronique comportant :
- un substrat s'étendant suivant un plan de référence ;
- une première structure de grille déposée sur le substrat, la première structure de grille présentant au moins un flanc latéral ;
- un empilement comprenant plusieurs couches et dont au moins une desdites couches est apte à stocker des charges électriques, ledit empilement recouvrant au moins le flanc latéral de la première structure de grille et une partie du substrat ;
ledit procédé de fabrication de l'espaceur comportant les étapes suivantes :
- dépôt d'une couche d'un matériau de l'espaceur au moins sur la zone recouverte par l'empilement ;
- usinage ionique de la couche du matériau de l'espaceur, ledit usinage ionique s'effectuant avec arrêt contrôlé de manière à conserver un reliquat de l'épaisseur de la couche du matériau de l'espaceur recouvrant l'empilement ;
- gravure plasma du reliquat de l'épaisseur de la couche du matériau de l'espaceur, dite « première gravure plasma ».

Le procédé selon l'invention combine avantageusement deux gravures successives aux propriétés différentes pour la fabrication d'un espaceur pour mémoire électronique ayant une longueur contrôlée et possédant un volume de matériau important tout en permettant une diminution de la complexité et donc du coût de fabrication.

Le procédé selon l'invention met tout d'abord à profit le caractère très anisotrope d'un usinage ionique, qui permet de conserver la forme et le volume du matériau de l'espaceur initialement déposé et recouvrant latéralement l'empilement déposé, de manière beaucoup plus satisfaisante qu'en utilisant, par exemple, une technique de gravure sèche, classiquement utilisée dans l'état de la technique. L'usinage ionique, qui génère des re-dépôts importants sur les épaisseurs gravées et des surfaces rugueuses non compatibles avec les états de surface attendus en microélectronique, est considérée comme impropre par l'homme du métier. De plus, elle ne permet pas une bonne sélectivité entre différentes couches de matériaux, ce qui la rend a priori inutilisable dans la réalisation des parties critiques d'un transistor.

Le procédé selon l'invention termine ensuite la gravure du reliquat de l'épaisseur de la couche du matériau de l'espaceur avec une première gravure plasma, utilisant avantageusement le caractère sélectif d'une telle gravure afin de ne pas entamer l'empilement. En outre, la première gravure plasma permet avantageusement d'améliorer l'état de surface précédemment obtenu par usinage ionique.

Dans ce document, on entend par « reliquat de l'épaisseur d'une couche A » une épaisseur résiduelle de la couche A, qui subsiste après que le reste de l'épaisseur de la couche A ait été gravé par usinage ionique et qui est typiquement inférieure à la moitié de l'épaisseur initiale de la couche A.

Dans ce document, sauf précision contraire, on emploie le terme « espaceur » sans préjuger du caractère isolant ou conducteur dudit espaceur.

Outre les caractéristiques qui viennent d'être évoquées dans le paragraphe précédent, le procédé selon l'invention peut présenter une ou plusieurs caractéristiques complémentaires parmi les suivantes, considérées individuellement ou selon toutes les combinaisons techniquement possibles :
- La couche déposée de matériau de l'espaceur est une couche de silicium amorphe dopé ou de silicium polycristallin dopé. Plus généralement, la couche déposée peut être constituée d'autres types de matériaux semiconducteurs, par exemple un matériau à base de Ge ou un mélange de Si et de Ge. Dans certaines configurations également, un métal tel le TiN pourra être déposé juste avant le matériau semi-conducteur pour augmenter le travail de sortie.
   Ainsi, le/les matériau/x de l'espaceur est/sont compatible/s avec un matériau de grille d'une cellule mémoire électronique. L'espaceur ainsi réalisé peut contribuer à former une deuxième structure de grille d'une cellule mémoire électronique à double grille, la deuxième structure de grille étant réalisée sous la forme d'un espaceur de la première structure de grille.
- Le dépôt de la couche du matériau de l'espaceur est effectué sur une épaisseur sensiblement comprise entre 0,75*e₁ et 3*e₁, où e1 est la hauteur de la première grille. Par exemple, si e₁=50 nm, l'épaisseur de l'espaceur pouvant être raisonnablement déposée sera sensiblement comprise entre 38 nm et 150 nm.
   Ainsi, on peut choisir la largeur de l'espaceur ultérieurement réalisé.
- L'usinage ionique utilisé est un usinage ionique à l'Argon.
   Ainsi on utilise, dans un contexte nouveau, un gaz inerte usuellement impliqué dans un procédé maîtrisé, ne générant donc pas de surcoût.
- L'usinage ionique utilisé possède une incidence de 40° par rapport au plan de référence du substrat.
   Ainsi on utilise, dans un contexte nouveau, un paramètre d'incidence usuel d'un procédé maîtrisé, ne générant donc pas de surcoût.
- A l'issue de l'usinage ionique, le reliquat de l'épaisseur de la couche du matériau de grille de la deuxième structure de grille a une épaisseur comprise entre 15 nanomètres et 20 nanomètres.
   Ainsi, l'épaisseur du reliquat est à la fois suffisamment importante pour permettre le bon fonctionnement d'une détection de fin d'attaque (DFA) et suffisamment faible pour que l'étape de première gravure plasma soit de courte durée. L'observation d'une DFA assure en effet la sélectivité de la première gravure plasma utilisée dans le procédé après l'étape d'usinage ionique. Dans le même temps, la première gravure plasma responsable de l'élimination de l'épaisseur du reliquat doit être la plus rapide possible pour ne pas entamer le matériau de l'espaceur recouvrant latéralement l'empilement. En effet, si l'épaisseur du reliquat à éliminer avec la première gravure plasma est trop importante, on perd le bénéfice de l'étape d'usinage ionique et la forme finale de l'espaceur en sera affectée, c'est-à-dire qu'on retrouvera une forme d'espaceur quai-triangulaire.
- Le procédé possède, postérieurement à la première gravure plasma, une deuxième gravure plasma de l'empilement non recouvert par le matériau de l'espaceur après la première gravure plasma, ladite deuxième gravure plasma s'effectuant le plus sélectivement possible par rapport au matériau de l'espaceur afin de ne pas graver le matériau de l'espaceur ou de le graver le moins possible.
   Ainsi, on contribue à permettre une reprise de contact ultérieure sur la première structure de grille.
- La deuxième gravure plasma s'effectue suivant une direction sensiblement perpendiculaire au plan de référence de manière à conserver la forme et le volume du matériau de l'espaceur recouvrant latéralement l'empilement. Ainsi, on préserve le bénéfice de l'usinage ionique et de la première gravure plasma.
- La deuxième gravure plasma est une gravure par un plasma fluoré, sans Argon et avec une dilution à l'Hélium.
   Ainsi, on obtient un plasma suffisamment anisotrope et sélectif entre l'empilement et le matériau de grille. L'état de la technique ne propose en effet que des gravures standards, à base de composés chlorés, sélectives mais plutôt isotropes, ce qui entraîne une gravure latérale du matériau de l'espaceur recouvrant latéralement l'empilement et donc l'apparition d'un profil triangulaire pour cet espaceur. L'utilisation d'un plasma fluoré avec de l'Argon permettrait d'améliorer l'anisotropie de la gravure et donc de diminuer la gravure latérale du matériau de l'espaceur, cependant cela entraînerait en contrepartie une faible sélectivité de la gravure par rapport au matériau de l'espaceur. Le procédé selon l'invention propose donc une deuxième gravure plasma à base de composés fluorés, sans Argon et avec une forte dilution à l'Hélium afin d'accroître la sélectivité de la deuxième gravure plasma par rapport au matériau de l'espaceur et éviter sa gravure latérale.
- Le plasma utilisé lors de la deuxième gravure plasma est un mélange de difluorométhane, d'hélium et d'oxygène, avec deux fois plus d'hélium que d'oxygène et quatre fois plus de difluorométhane que d'oxygène.

Un deuxième objet de l'invention concerne un procédé de fabrication d'une cellule mémoire électronique comportant :
- un substrat s'étendant suivant un plan de référence ;
- une première structure de grille déposée sur le substrat, la première structure de grille présentant au moins un flanc latéral ;
- un empilement comprenant plusieurs couches et dont au moins une desdites couches est apte à stocker des charges électriques, ledit empilement recouvrant au moins le flanc latéral de la première structure de grille et une partie du substrat ;
- une deuxième structure de grille isolée de la première structure de grille et du substrat par l'empilement, la deuxième structure de grille étant un espaceur de la première structure de grille ;
la fabrication de la deuxième structure de grille comportant un procédé de fabrication d'un espaceur selon invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 représente schématiquement un exemple de cellule mémoire à double grille selon l'état de la technique ;
- La figure 2 illustre une première étape d'un procédé de fabrication d'une cellule mémoire électronique selon l'invention ;
- Les figures 3a à 3c illustrent les étapes d'un procédé de fabrication d'espaceurs pour cellule mémoire électronique selon l'invention ;
- La figure 4 illustre une étape d'un procédé de fabrication d'une cellule mémoire électronique selon un premier mode de réalisation de l'invention ;
- Les figures 5a à 5d illustrent certaines étapes d'un procédé de fabrication d'une cellule mémoire électronique selon un deuxième mode de réalisation de l'invention.

### DESCRIPTION DETAILLEE D'AU MOINS UN MODE DE REALISATION DE L'INVENTION

Pour plus de clarté, les éléments identiques ou similaires sont repérés par des signes de référence identiques sur l'ensemble des figures.

Un procédé 100 de fabrication d'une cellule mémoire électronique selon un premier mode de réalisation de l'invention est représenté aux figures 2, 3a à 3d et 4.

Un procédé 100' de fabrication d'une cellule mémoire électronique selon un deuxième mode de réalisation de l'invention est représenté aux figures 2, 3a à 3d et 5a à 5d.

Une première étape 101 du procédé 100 est illustrée à la figure 2. Selon la première étape 101, on commence par fabriquer une première structure de grille 301, dite grille du transistor de sélection ou grille du transistor de commande, sur un substrat 300. Le matériau semi-conducteur du substrat 300 est dans l'exemple représenté du silicium. Le substrat 300 s'étend suivant un plan de référence. La première structure de grille 301 possède un premier flanc latéral 309 et un deuxième flanc latéral 310. La première structure de grille 301 possède une épaisseur e1 mesurée suivant une direction perpendiculaire au plan de référence du substrat. Cette épaisseur e1 est typiquement comprise entre 50 nanomètres et 150 nanomètres. La première structure de grille 301 est composée d'une couche diélectrique de grille 302 et d'une couche conductrice 303. La couche diélectrique de grille 302 peut être réalisée par oxydation thermique du matériau semiconducteur formant le substrat 300. La couche conductrice 303 est par exemple réalisée en polysilicium. On réalise ensuite le dépôt d'un empilement 304 de plusieurs couches, dont au moins une couche est apte à stocker des charges électriques. Dans l'exemple représenté, l'empilement 304 est un empilement tri-couches d'oxyde-nitrure-oxyde, dit ONO. L'empilement 304 est formé d'une première couche 305 diélectrique, par exemple en dioxyde de silicium SiO₂, d'une deuxième couche 306 réalisée dans un matériau apte à stocker des charges électriques, par exemple du nitrure de silicium Si₃N₄, et d'une troisième couche 307 diélectrique, par exemple en dioxyde de silicium SiO₂. La deuxième couche 306 peut également être une couche constituée de nanocristaux de Si. Le dépôt de l'empilement 304 est réalisé de manière à recouvrir la première structure de grille 301.

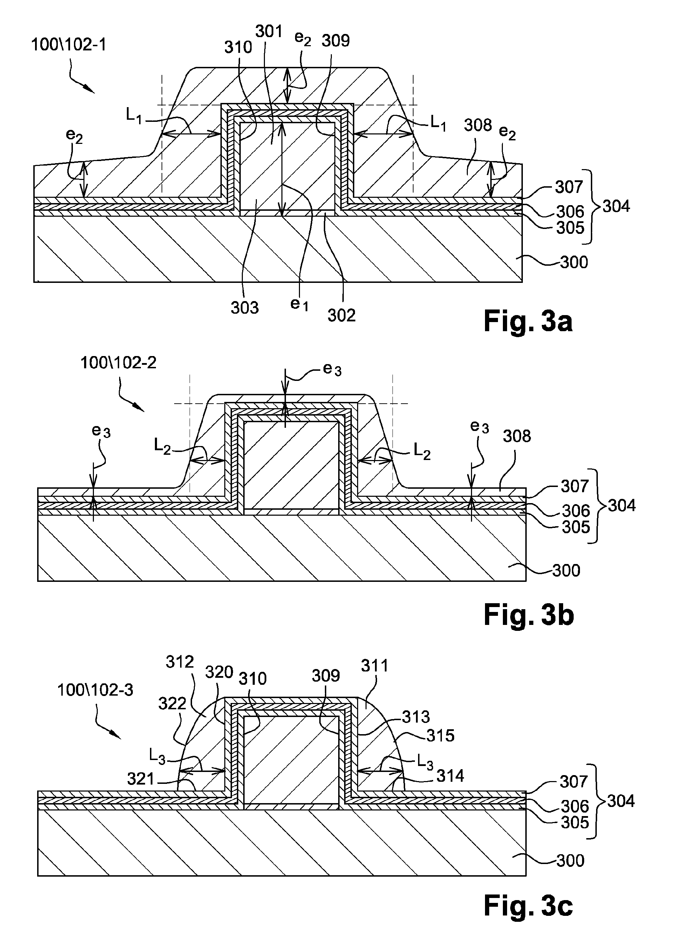

Une deuxième étape 102 du procédé 100 est illustrée aux figures 3a à 3c. La deuxième étape 102 est une étape de fabrication d'espaceur qui comprend trois sous-étapes :
- une première sous-étape 102-1 est illustrée à la figure 3a ;
- une deuxième sous-étape 102-2 est illustrée à la figure 3b ;
- une troisième sous-étape 102-3 est illustrée à la figure 3c.

Selon la première sous-étape 102-1, illustrée à la figure 3a, on réalise le dépôt d'une couche 308 du matériau d'un espaceur, par exemple en utilisant un dépôt chimique en phase vapeur basse pression LPCVD (« Low Pressure Chemical Vapour Déposition »).

Le matériau de l'espaceur correspond, dans l'exemple représenté, à un matériau de grille d'une deuxième structure de grille, par exemple du silicium amorphe ou polycristallin dopé. Ce dépôt de la couche 308 est réalisé de manière à recouvrir l'empilement 304 précédemment déposé. La couche 308 possède une épaisseur e2 mesurée suivant une direction verticale, sensiblement perpendiculaire au plan de référence du substrat et une longueur L1 mesurée suivant une direction horizontale, sensiblement perpendiculaire aux flancs latéraux 309 et 310 de la première structure de grille 301. La longueur L1 est reliée à la longueur de l'espaceur réalisé par la suite : idéalement, la longueur de l'espaceur obtenue est égale à L1. L'épaisseur e2 et la longueur L1 possèdent le même ordre de grandeur et sont typiquement comprises entre 0,75*e₁ et 3*e₁. Plus le dépôt est conforme, plus l'épaisseur e2 est proche de la longueur L1.

Selon la deuxième sous-étape 102-2, illustrée à la figure 3b, on effectue un usinage ionique d'une partie de l'épaisseur e2 de la couche 308. On souhaite en effet obtenir, à l'issue de cette deuxième sous-étape 102-2, une longueur L2 de matériau de grille recouvrant latéralement l'empilement 304 la plus contrôlée possible. La longueur L2 est nécessairement inférieure ou égale à la longueur L1. La technique de gravure choisie est donc avantageusement la plus anisotrope possible : plus la technique de gravure choisie est anisotrope, meilleure est la conservation du matériau de grille recouvrant latéralement l'empilement 304 et plus L2 est proche de L1.

L'usinage ionique permet d'attaquer principalement les parties de la couche 308 qui sont parallèles au plan de référence du substrat tout en attaquant beaucoup moins les parties de la couche 308 qui sont perpendiculaires au plan de référence du substrat. La forte anisotropie de l'usinage ionique permet avantageusement de conserver la forme et le volume du matériau de grille de la couche 308 recouvrant latéralement l'empilement 304 de manière beaucoup plus satisfaisante qu'en utilisant, par exemple, une technique de gravure sèche, moins anisotrope, classiquement utilisée dans l'état de la technique.

L'arrêt de l'usinage ionique est contrôlé de manière à conserver un reliquat e3 de l'épaisseur e2 de la couche 308 du matériau de grille recouvrant l'empilement 304 suivant une direction sensiblement parallèle au plan de référence et à ne pas graver l'empilement 304. Ce reliquat e3 a avantageusement une épaisseur comprise entre 15 nanomètres et 20 nanomètres. Nous reviendrons dans la suite de ce document sur le choix de l'épaisseur du reliquat.

Dans l'exemple représenté, l'usinage ionique est un usinage ionique à l'Argon (Ar) utilisé dans les conditions standards d'usinage, avec un courant de 100 mA et une incidence de 40° par rapport au plan de référence du substrat. Dans ces conditions d'usinage, la vitesse d'usinage du silicium polycristallin est comprise entre 12 et 13 nanomètres par minute. Typiquement, dans le cas où l'on veut conserver un reliquat e3 de silicium polycristallin d'épaisseur comprise entre 15 et 20 nanomètres, les temps indicatifs d'usinage ionique requis sont les suivants :
- 4 minutes pour un dépôt initial d'une couche 308 de silicium polycristallin avec e2 = 65 nanomètres ;
- 5 minutes et 50 secondes pour un dépôt initial d'une couche 308 de silicium polycristallin avec e2 = 90 nanomètres ;
- 9 minutes pour un dépôt initial d'une couche 308 de silicium polycristallin avec e2 = 130 nanomètres.

Selon la troisième sous-étape 102-3, illustrée à la figure 3c, on effectue une première gravure plasma du reliquat e3 de l'épaisseur e2 de la couche 308 du matériau de l'espaceur. A l'issue cette première gravure plasma, le reliquat e3 est éliminé. La première gravure plasma est réalisée suivant une direction sensiblement perpendiculaire au plan de référence de manière à conserver au mieux la forme et le volume du matériau de grille de la couche 308 recouvrant latéralement l'empilement 304. Cette première gravure plasma s'effectue sélectivement par rapport à l'empilement 304, de manière à ne pas graver l'empilement 304. La première gravure plasma est, dans le mode de réalisation ici décrit, réalisée dans un réacteur plasma à couplage inductif ICP (Inductively Coupled Plasma en anglais). Ce type de réacteur permet d'ajuster les composantes physiques et chimiques du plasma afin d'optimiser la sélectivité entre matériaux au cours d'une gravure plasma.

Nous revenons ici sur le choix de l'épaisseur du reliquat e3. La sélectivité de la technique de gravure sèche par plasma se fait avec l'observation d'une Détection de Fin d'Attaque (DFA). Dans le cas d'un matériau de l'espaceur, et donc d'un reliquat e3, en silicium polycristallin, une couche d'oxyde natif se forme en surface dès que le matériau de l'espaceur est exposé à l'air ambiant. L'épaisseur du reliquat e3 doit être suffisante pour que la DFA discerne le passage de cet oxyde natif au silicium polycristallin du matériau de grille, puis le passage du silicium polycristallin au matériau diélectrique de grille de la couche 307. L'épaisseur du reliquat e3 doit en même temps être suffisamment faible pour que la première gravure plasma responsable de son élimination soit rapide et n'entame pas le matériau de l'espaceur recouvrant latéralement l'empilement 304. Si l'épaisseur du reliquat e3 à éliminer est trop importante, on perd le bénéfice de la première étape d'usinage ionique. En pratique, une épaisseur de 15 à 20 nanomètres pour le reliquat e3 permet le bon fonctionnement de la DFA et assure également une deuxième étape de gravure plasma de courte durée.

On commence par supprimer l'oxyde natif, ce qui peut être réalisé en quelques secondes en utilisant un plasma de 100 sccm (centimètre cube standard ou standard cubic centimeter en anglais) de tétrafluorure de carbone CF₄ à la pression de 4 mTorr avec une puissance de 350 Watt sur la bobine et 50 Watt de polarisation (« bias » selon la terminologie anglaise). On élimine ensuite l'épaisseur du reliquat e3 avec un mélange de bromure d'hydrogène, de chlore et de tétrafluorure de carbone sous une pression de 4 mTorr avec une puissance de 450 Watt sur la bobine et un bias de 70 Watt. Grâce à ce procédé, on observe à l'issue de la première gravure plasma une gravure latérale du matériau de l'espaceur recouvrant latéralement l'empilement 304 inférieure à 6 nanomètres. On a donc, à l'issue de cette première gravure plasma, une longueur L3 du matériau de l'espaceur recouvrant latéralement l'empilement 304 telle que : L3 ≥ L2 - 6 nanomètres. Il est donc possible de contrôler, en fonction de la longueur L1 de la couche 308 initialement déposée, la longueur L3 des espaceurs ultérieurement réalisés.

Le matériau de l'espaceur résiduel, qui constituait initialement la couche 308, forme désormais un premier espaceur 311 et un deuxième espaceur 312 de la première structure de grille 301. Le premier espaceur 311 et le deuxième espaceur 312 ont une longueur L3.

Le premier espaceur 311 obtenu à l'issue de cette troisième sous-étape 102-3 comporte :
- une première face latérale 313 sensiblement perpendiculaire au plan de référence du substrat et au contact de l'empilement 304, de telle sorte que l'empilement 304 sépare le premier flanc latéral 309 de la première structure de grille 301 et la première face latérale 313 ;
- une face inférieure 314 de longueur L3, sensiblement parallèle au plan de référence du substrat et au contact de l'empilement 304, de telle sorte que l'empilement 304 sépare le substrat 300 et la face inférieure 314 ;
- une deuxième face latérale 315, arrondie, reliant la première face latérale 313 et la face inférieure 314.

Le deuxième espaceur 312 obtenu à l'issue de cette troisième sous-étape 102-3 du procédé 200 comporte :
- une première face latérale 320 sensiblement perpendiculaire au plan de référence du substrat et au contact de l'empilement 304, de telle sorte que l'empilement 304 sépare le premier flanc latéral 310 de la première structure de grille 301 et la première face latérale 320 ;
- une face inférieure 321 de longueur L3, sensiblement parallèle au plan de référence du substrat et au contact de l'empilement 304, de telle sorte que l'empilement 304 sépare le substrat 300 et la face inférieure 314 ;
- une deuxième face latérale 322, arrondie, reliant la première face latérale 320 et la face inférieure 321.

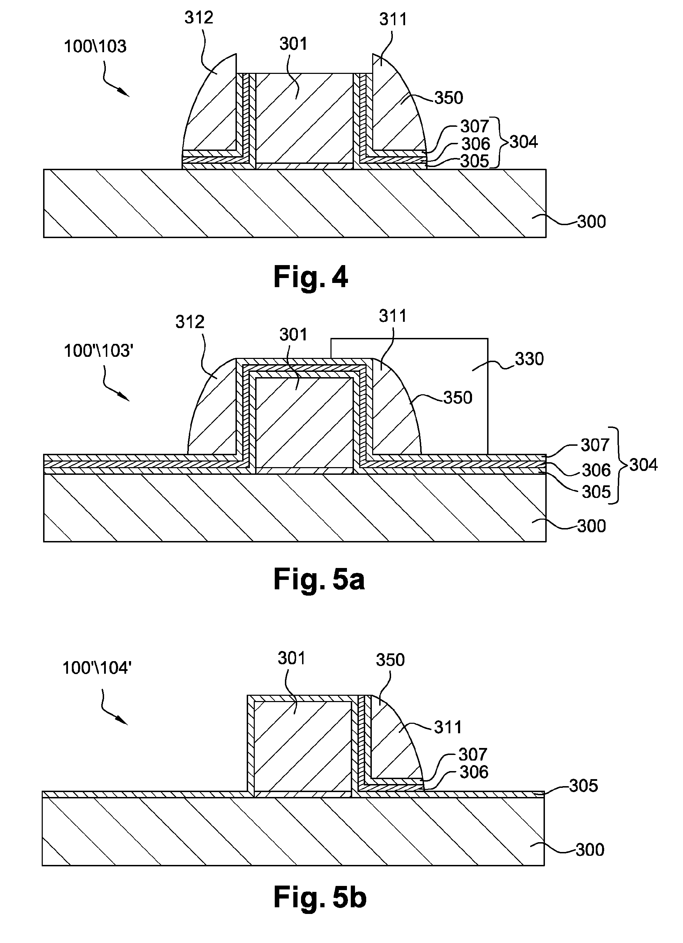

Une troisième étape 103 du procédé 100 est illustrée à la figure 4. Selon la troisième étape 103, une deuxième gravure plasma est effectuée afin d'éliminer l'empilement 304 non recouvert par le matériau de l'espaceur résiduel formant les espaceurs 311 et 312. Ainsi, on contribue en particulier à permettre une reprise de contact ultérieure sur la première structure de grille 301 et sur les zones de source et de drain. Cette deuxième gravure plasma doit s'effectuer sélectivement par rapport au matériau des espaceurs 311 et 312 afin de conserver un important volume de matériau pour ces espaceurs 311 et 312 et ne pas dégrader la forme de ces espaceurs, ou de les dégrader le moins possible. L'état de la technique propose pour ce faire des gravures standards, à base de composés chlorés, plutôt isotropes, ce qui entraînerait une gravure latérale des espaceurs 311 et 312 et l'apparition d'un profil triangulaire pour lesdits espaceurs 311 et 312. L'utilisation d'un plasma fluoré avec de l'Argon permettrait d'améliorer l'anisotropie de la gravure et donc de diminuer la gravure latérale des espaceurs 311 et 312, cependant cela entraînerait en contrepartie une faible sélectivité de la deuxième gravure plasma par rapport au matériau des espaceurs 311 et 312. Le procédé selon l'invention propose de réaliser une deuxième gravure plasma à base de composés fluorés, sans Argon et avec une forte dilution à l'Hélium afin d'accroître la sélectivité par rapport au matériau de l'espaceur et éviter la gravure latérale des espaceurs 311 et 312. Ainsi, un mélange de difluorométhane, d'hélium et d'oxygène dans les proportions suivantes : 4/2/1, c'est-à-dire avec quatre fois plus de difluorométhane que d'oxygène et deux fois plus d'hélium que d'oxygène, à une pression de 4 mTorr, avec une puissance bobine de 150 Watt et une puissance de bias de 70 Watt, permet d'obtenir un plasma suffisamment anisotrope et sélectif entre le diélectrique de grille de la couche 305 et le silicium. Différents essais entre 20 Watt et 110 Watt de bias ont permis d'optimiser cette sélectivité à 5,7 entre le nitrure et le polysilicium et à 1,28 entre l'oxyde et le polysilicium. Des espaceurs 311 et 312 avec une longueur L3 de 70, 90 et 120 nanomètres ont ainsi été réalisés pour une première structure de grille 301 avec une épaisseur e1 de 50 nanomètres puis avec une épaisseur e1 de 150 nanomètres.

On décrit désormais le procédé 100' de fabrication d'une cellule mémoire électronique selon le deuxième mode de réalisation de l'invention. Le procédé 100' permet l'obtention d'une cellule mémoire électronique selon l'invention avec un seul espaceur. Le procédé 100' comporte la première étape 101 et la deuxième étape 102 précédemment décrites. Suite à la deuxième étape 102, le procédé 100' comporte une troisième étape alternative 103', puis des quatrième, cinquième et sixième étapes 104', 105' et 106', respectivement illustrées aux figures 5a à 5d.

La troisième étape alternative 103' du procédé 100' est illustrée à la figure 5a. Selon la troisième étape alternative 103', une résine protectrice 330, par exemple une résine photosensible, est déposée sur l'espaceur 311 et sur une partie de la première structure de grille 301. On retire ensuite l'espaceur 312, non protégé par la résine 330, par exemple au moyen d'une gravure ionique réactive RIE (« Reactive Ion Etching »). La résine protectrice 330 est alors retirée à son tour, par exemple avec un procédé d'enlèvement résine (stripping). Dans ce deuxième mode de réalisation de l'invention où le deuxième espaceur 312 est éliminé et où seul le premier espaceur 311 est conservé, le premier espaceur 311 contribue avantageusement à former une deuxième structure de grille 350 de la cellule mémoire électronique.

La quatrième étape 104' du procédé 100' est illustrée à la figure 5b. Selon la quatrième étape 104', on réalise le retrait de la troisième couche 307 et de la deuxième couche 306 de l'empilement 304 non recouvertes par l'espaceur 311, avec arrêt sur la première couche 305. Seule la gravure de la troisième couche 307 et de la deuxième couche 306 est réalisée, avec arrêt sur la première couche 305, pour des raisons d'arrêt de gravure et d'implantation que nous détaillerons par la suite. Dans le cas d'un empilement 304 de type ONO, ce retrait peut être réalisé par une technique de gravure sèche telle qu'une gravure ionique réactive RIE avec arrêt sur la première couche 305 de SiO₂.

La quatrième étape 104' peut ensuite comprendre une première implantation ionique (non représentée). Cette étape comporte généralement un dopage de type LDD (« Low Doped Drain ») permettant notamment de doper à dose moyenne la surface de l'espaceur 311. Selon que le transistor que l'on souhaite réaliser est du type PMOS ou NMOS, les ions sont choisis de façon à réaliser des zones d'un type de conductivité p ou n. On comprend donc pourquoi seule la gravure de la troisième couche 307 et la deuxième couche 306 est effectuée dans un premier temps :
- Tout d'abord, la première couche 305 sert de couche d'arrêt : consommer légèrement ladite première couche 305 ne pose aucun problème car elle est destinée à être enlevée.
- Ensuite, la présence de quelques nanomètres de matériau grâce à la première couche 305 permet d'effectuer l'implantation sans abîmer le substrat 300. La première couche 305 sera endommagée par l'implantation, mais ceci ne pose aucun problème car elle sera enlevée par la suite.

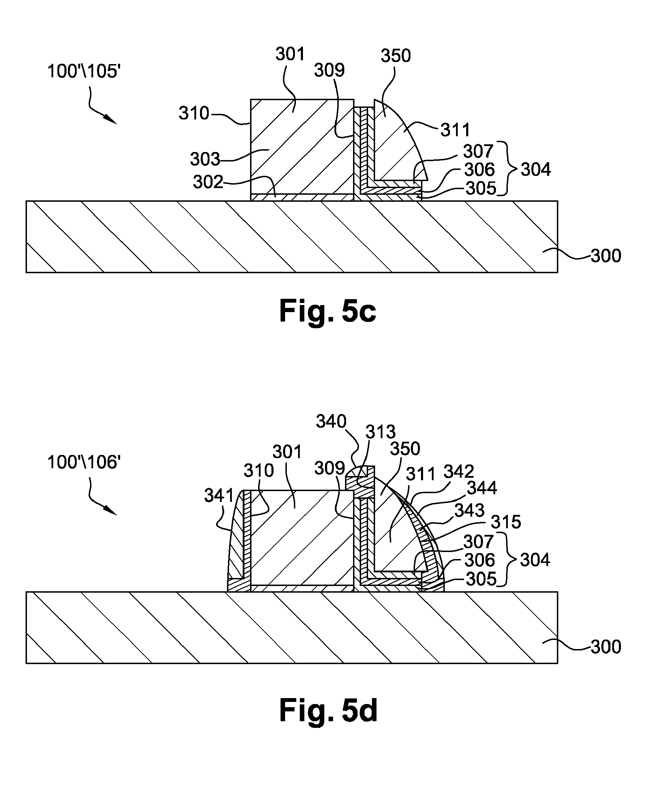

La cinquième étape 105' du procédé 100' est illustrée à la figure 5c. Selon la cinquième étape 105', on réalise le retrait de la première couche 305 de l'empilement ONO 304. Ce retrait est par exemple réalisé par gravure humide isotrope avec une solution partiellement diluée d'acide fluorhydrique (HF) de manière à avoir une bonne sélectivité du retrait de SiO₂ formant la couche 305 par rapport au substrat 300 (ici substrat silicium). Le retrait de la première couche 305 de l'empilement 304 peut également être réalisé par la technique précédemment décrite de gravure plasma à base de composés fluorés, sans Argon et avec une forte dilution à l'Hélium, afin d'accroître la sélectivité par rapport au matériau de l'espaceur et éviter la gravure latérale de l'espaceur 311. Ladite technique de gravure plasma met en oeuvre en mélange de difluorométhane, d'hélium et d'oxygène dans les proportions suivantes : 4/2/1, c'est-à-dire avec quatre fois plus de difluorométhane que d'oxygène et deux fois plus d'hélium que d'oxygène, à une pression de 4 mTorr, avec une puissance bobine de 150 Watt et une puissance de bias de 70 Watt, ce qui permet d'obtenir un plasma suffisamment anisotrope et sélectif entre le diélectrique de grille de la couche 305 et le silicium.

La sixième étape 106' du procédé 100' est illustrée à la figure 5d. Selon la sixième étape 106', on réalise différentes régions isolantes de la cellule mémoire électronique, à savoir :
- une première région isolante 340 s'étendant sur la partie de la première face latérale 313 de l'espaceur 311 qui n'est pas en contact avec l'empilement 304 ;
- une deuxième région isolante 341 s'étendant sur le deuxième flanc latéral 310 de la première structure de grille 301 ;
- une troisième région isolante 342 s'étendant sur la deuxième face latérale 315 de l'espaceur 311.

Chacune des régions isolantes 340, 341 et 342 est formée d'un matériau diélectrique, qui peut par exemple être une bicouche oxyde/nitrure, par exemple, une couche de SiO₂ HTO (de l'anglais « High Temperature Oxyde ») et une couche de Si₃N₄. Pour ce faire, on commence par déposer une première couche 343 d'oxyde dite HTO obtenue par exemple par dépôt chimique en phase vapeur à basse pression (LPCVD). Typiquement, une épaisseur de 10 nm est déposée. En tout état de cause, cette épaisseur doit être suffisante pour combler les vides résultant de la gravure des couches d'oxyde de l'empilement 304 intervenue précédemment. Cette couche permet une bonne accroche de la couche de Si₃N₄ déposée par la suite, et remplit également le rôle de couche d'arrêt à la gravure du Si₃N₄. On réalise ensuite le dépôt d'une deuxième couche 344, par exemple une couche de nitrure de silicium (Si₃N₄). Ce dépôt peut être réalisé par la même technique que ci-dessus de dépôt LPCVD. On dépose une couche de nitrure de silicium qui est typiquement comprise dans une gamme d'épaisseur allant de 20 nm et 40 nm.
Les régions isolantes sont obtenues par gravure de type gravure ionique réactive RIE. On grave de manière anisotrope les couches 343 et 344 de matériau isolant précédemment déposées de manière à conserver les parties verticales et à supprimer les parties horizontales de ces couches.

La sixième étape 106' peut ensuite comprendre une deuxième implantation ionique (non représentée). Cette étape permet notamment de doper à plus forte énergie une partie de l'espaceur 311 et de la première structure de grille 301, ainsi que le haut du substrat (correspondant aux zones de source et de drain). Selon que le transistor que l'on souhaite réaliser est du type PMOS ou NMOS, les ions sont choisis de façon à réaliser des zones d'un type de conductivité p ou n. Ainsi, dans le cas de la réalisation d'un transistor n-MOS sur un substrat 300 de type p, une partie du volume de l'espaceur 311, de la première structure de grille 301 et des zones de source et de drain seront dopées n+.

La sixième étape 106' peut ensuite comprendre un recuit d'implantation (non représenté), dit également « recuit d'activation », afin d'activer les atomes dopants et de guérir les défauts dus au bombardement lors de la première implantation ionique et/ou lors de la deuxième implantation ionique.
Naturellement l'invention n'est pas limitée aux modes de réalisation décrits en référence aux figures et des variantes pourraient être envisagées sans sortir du cadre de l'invention.

## Revendications

1. Procédé (200) de fabrication d'un espaceur (311, 312) pour mémoire électronique, la mémoire électronique comportant :
- un substrat (300) s'étendant suivant un plan de référence ;
- une première structure de grille (301) déposée sur le substrat (300), la première structure de grille (301) présentant au moins un flanc latéral (309, 310) ;
- un empilement (304) comprenant plusieurs couches et dont au moins une desdites couches est apte à stocker des charges électriques, ledit empilement (304) recouvrant au moins le flanc latéral (309, 310) de la première structure de grille (301) et une partie du substrat (300) ;
ledit procédé (200) de fabrication de l'espaceur (311, 312) étant **caractérisé en ce qu'**il comporte les étapes suivantes :
- dépôt d'une couche (308) d'un matériau de l'espaceur au moins sur la zone recouverte par l'empilement (304) ;
- usinage ionique de la couche (308) du matériau de l'espaceur, ledit usinage ionique s'effectuant avec arrêt contrôlé de manière à conserver un reliquat (e3) de l'épaisseur de la couche (308) du matériau de l'espaceur recouvrant l'empilement (304) ;
- gravure plasma du reliquat (e3) de l'épaisseur de la couche (308) du matériau de l'espaceur, dite « première gravure plasma ».

2. Procédé suivant la revendication précédente **caractérisé en ce que** le matériau de l'espaceur est du silicium amorphe dopé ou du silicium polycristallin dopé.

3. Procédé selon l'une quelconque des revendications précédentes **caractérisé en ce que** l'usinage ionique est un usinage ionique à l'Argon.

4. Procédé selon l'une quelconque des revendications précédentes **caractérisé en ce que** l'usinage ionique est réalisé avec une incidence de 40°.

5. Procédé selon l'une quelconque des revendications précédentes, **caractérisé en ce que** le reliquat (e3) de l'épaisseur de la couche (308) du matériau de l'espaceur a une épaisseur comprise entre 10 nanomètres et 20 nanomètres et préférentiellement entre 15 nanomètres et 20 nanomètres.

6. Procédé selon l'une quelconque des revendications précédentes **caractérisé en ce que** le dépôt de la couche (308) du matériau de l'espaceur est effectué sur une épaisseur comprise entre 0,75*e1 et 3*e1, où e1 est la hauteur de la première grille (301).

7. Procédé selon l'une quelconque des revendications précédentes **caractérisé en ce que** le procédé possède, postérieurement à la première gravure plasma, une deuxième gravure plasma de l'empilement (304) non recouvert par le matériau de l'espaceur après la première gravure plasma, ladite deuxième gravure plasma s'effectuant sélectivement par rapport au matériau de l'espaceur.

8. Procédé suivant la revendication précédente **caractérisé en ce que** la deuxième gravure plasma est une gravure par un plasma fluoré, sans Argon et avec une dilution à l'Hélium.

9. Procédé selon l'une quelconque des revendications 7 ou 8 **caractérisé en ce que** le plasma utilisé lors de la deuxième gravure plasma est un mélange de difluorométhane, d'hélium et d'oxygène, avec deux fois plus d'hélium que d'oxygène et quatre fois plus de difluorométhane que d'oxygène.

10. Procédé (100) de fabrication d'une cellule mémoire électronique comportant :
- un substrat (300) s'étendant suivant un plan de référence ;
- une première structure de grille (301) déposée sur le substrat (300), la première structure de grille (301) présentant au moins un flanc latéral (309, 310) ;
- un empilement (304) comprenant plusieurs couches et dont au moins une desdites couches est apte à stocker des charges électriques, ledit empilement recouvrant au moins le flanc latéral de la première structure de grille et une partie du substrat ;
- une deuxième structure de grille (350) isolée de la première structure de grille (301) et du substrat (300) par l'empilement (304), la deuxième structure de grille (350) étant un espaceur de la première structure de grille (301) ;
ledit procédé (100) étant **caractérisé en ce que** la réalisation de la deuxième structure de grille (350) comporte un procédé (200) de fabrication d'un espaceur selon l'une quelconque des revendications précédentes.
